(19) Europäisches Patentamt
European Patent Office
Office européen des brevets

(11) **EP 3 440 473 B1**

(12) **EUROPEAN PATENT SPECIFICATION**

(45) Date of publication and mention
of the grant of the patent:
**18.03.2020 Bulletin 2020/12**

(21) Application number: **17715146.1**

(22) Date of filing: **03.04.2017**

(51) Int Cl.:
*G01R 31/42* *(2006.01)* *G01R 31/08* *(2020.01)*

(86) International application number:
**PCT/EP2017/057859**

(87) International publication number:
**WO 2017/174511 (12.10.2017 Gazette 2017/41)**

(54) **IMPROVEMENTS IN OR RELATING TO THE DETECTION OF A FAULT ON A POWER CONVERTER**

VERBESSERUNGEN BEI ODER IM ZUSAMMENHANG MIT DER ERKENNUNG EINES FEHLERS AN EINEM LEISTUNGSWANDLER

AMÉLIORATIONS DE LA DÉTECTION D'UNE DÉFAILLANCE SUR UN CONVERTISSEUR DE PUISSANCE OU RELATIVES À UNE TELLE DÉTECTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.04.2016 GB 201605804**

(43) Date of publication of application:
**13.02.2019 Bulletin 2019/07**

(73) Proprietor: **General Electric Technology GmbH 5400 Baden (CH)**

(72) Inventors:
• **BRIFF, Pablo**
**Stafford**
**Staffordshire ST16 2QZ (GB)**
• **MORENO MUÑOZ, Francisco Jose**
**31780 Navarra (ES)**
• **DYKE, Kevin James**
**Stafford**
**Staffordshire ST17 4YA (GB)**

(74) Representative: **Brevalex**
**95, rue d'Amsterdam**
**75378 Paris Cedex 8 (FR)**

(56) References cited:
**WO-A1-2015/172810 US-A1- 2011 238 338**

**Description**

This invention relates to a method of detecting a fault on a far-end power converter within a DC transmission network, and to a DC transmission network including at least a near-end power converter that has a control unit programmed to determine whether there is a fault on an associated far-end power converter of interest.

In DC transmission networks, such as high voltage direct current (HVDC) power transmission networks, alternating current (AC) power is typically converted to direct current (DC) power for transmission via one or more portions overhead lines and/or under-sea cables. This conversion removes the need to compensate for the AC capacitive load effects imposed by the transmission medium, i.e. the transmission line or cable, and reduces the cost per kilometre of the lines and/or cables, and thus becomes cost-effective when power needs to be transmitted over a long distance.

The conversion between DC power and AC power is utilized in power transmission networks where it is necessary to interconnect the DC and AC electrical networks. In any such power transmission network, power converters are required at each interface between AC and DC power to effect the required conversion; AC to DC or DC to AC. Poor detection of a fault on such a power converter can potentially lead to damage in the converter hardware due to a rise in either current or voltage waveforms applied to the said hardware.

WO2015/172810 A1 discloses a method for fault level estimation for a power converter. According to a first aspect of the invention, the invention is defined by a method of detecting a fault on a far-end power converter within a DC transmission network comprising a near-end power converter and at least one far-end power converter interconnected with one another by one or more portions of transmission medium, the method comprising the steps of:

　　(a) establishing a linear time-invariant model of the transmission medium lying between the or each far-end power converter and the near-end power converter;

　　(b) determining a response characteristic of the time-invariant model;

　　(c) measuring an output operating property of the transmission medium at the near-end power converter;

　　(d) identifying one far-end power converter as a far-end power converter of interest;

　　(e) deriving a corresponding input operating property of the transmission medium at the far-end power converter of interest by applying an inverse of the response characteristic of the time-invariant model to the measured output operating property of the transmission medium at the near-end power converter; and

　　(f) comparing the derived input operating property of the transmission medium at the far-end power converter of interest with a fault characteristic to determine whether there is a fault on the far-end power converter of interest.

Establishing a linear time-invariant model of the transmission medium lying between the or each far-end power converter and the near-end power converter, determining a response characteristic of the time-invariant model, and then using this to derive an input operating property of the transmission medium at the far-end power converter of interest (with it being possible to evaluate such an input operating property to establish whether there is a fault on the far-end power converter of interest) permits such fault detection to take place without the need for a dedicated communication link between the near-end power converter and the far-end power converter of interest.

The absence of a need for such a communication link is particularly desirable because a fault on a given far-end power converter, i.e. a fault in the transmission medium between the power converters, can impair or degrade an existing communication link to the point that it is unreliable during the occurrence of a fault.

Preferably step (f) of comparing the derived input operating property of the transmission medium at the far-end power converter of interest with a fault characteristic to determine whether there is a fault on the far-end power converter of interest includes predicting whether the derived input operating property will meet the fault characteristic and indicating that there is a fault on the far-end power converter of interest when the derived input operating property is predicted to meet the fault characteristic.

Optionally predicting whether the derived input operating property will meet the fault characteristic includes determining an expected output operating property at least one step ahead.

Such features of the method assist in detecting occurrence of a fault on the far-end power converter of interest more quickly.

In addition the foregoing features are useful in cancelling out known delays such as measurement, processing, and data conversion delays, in the fault detection method of the invention.

Step (b) of determining a response characteristic of the time-invariant model may include establishing one or more of the following to describe the transformative effect the one or more portions of transmission medium has on the input operating property at the or each far-end power converter:

an impulse response;

a transfer function;

a differential equation; and

a difference equation.

The foregoing response characteristics are desirably able to fully describe a transformative effect within a linear time-invariant model.

In a preferred embodiment of the invention the method includes:

measuring one or both of a first output operating property in the form of a voltage of the transmission medium at the near-end power converter, and a second output operating property in the form of a current of the transmission medium at the near-end power converter; and

deriving one or both of a corresponding first input operating property in the form of a voltage of the transmission medium at the far-end power converter of interest, and a corresponding second input operating property in the form of a current of the transmission medium at the far-end power converter.

Comparison of either a first voltage input operating property or a second current input operating property of the transmission medium at the far-end power converter of interest with a corresponding voltage or current fault threshold can reliably and repeatedly be used to detect a fault on the far-end power converter of interest.

In another preferred embodiment of the invention both voltage and current output operating properties are measured and subsequently both corresponding voltage and current input operating properties are derived, and the method additionally includes the step of estimating the power at the far-end power converter of interest from the said derived voltage and current input operating properties.

Such a step provides an indication of the power demanded at a faulty far-end power converter, without the need to introduce communication links, hardware redundancy or additional fail-safe strategies.

A power estimate obtained in the foregoing manner can also be used as a power reference on the healthy side of the faulty far-end power converter to permit a ride through of the fault without collapsing the voltage carried by the transmission medium connected with the said faulty far-end power converter.

In method of detecting a fault on a far-end power converter, within a DC transmission network including a near-end power converter and a plurality of far-end power converters, step (d) of identifying one far-end power converter as a far-end power converter of interest preferably includes testing a respective hypothesis for each far-end power converter that a fault has occurred at the given far-end power converter and the or each other far-end power converter continues to operate normally.

Optionally the step of testing a respective hypothesis for each far-end power converter includes:

ascribing an estimated fault level input operating property of the transmission medium at the given far-end power converter at which the fault is postulated to have occurred;

utilising a known previous input operating property of the transmission medium at the or each other far-end power converter;

applying the response characteristic of the time-invariant model to the estimated fault level input operating property of the transmission medium at the given far-end power converter at which the fault is postulated to have occurred and to the known previous input operating property of the transmission medium at the or each other far-end power converter to obtain an expected theoretical output operating property of the transmission medium at the near-end power converter; and

comparing the expected theoretical output operating property of the transmission medium at the near-end power converter with the measured output operating property of the transmission medium at the near-end power converter.

In a further preferred embodiment of the invention the far-end power converter identified as the far-end power converter of interest is the power converter whose respective hypothesis results in the corresponding expected theoretical output operating property most closely matching the measured output operating property of the transmission medium.

The foregoing steps are able, advantageously, to identify the far-end power converter most likely to have a fault on it, with steps (c) and (f) of the invention then being able to confirm whether such a fault has actually arisen.

In a method of detecting a fault on a far-end power converter, within a DC transmission network including a near-end power converter, a plurality of far-end power converters and a current flow controller to balance internal currents flowing between the power converters which are mutually interconnected with one another, optionally a current output operating property is measured at the near-end power converter and the response characteristic of the time-invariant model additionally factors in the distribution of internal currents amongst the said power converters.

Preferably the response characteristic additionally factors in the distribution of internal current amongst the said power converters by including a weighting coefficient corresponding to each internal current flow between respective pairs of mutually interconnected power converters.

Such steps beneficially take into account the variation in circulating internal currents purposely carried out by the current flow controller, and hence permits other fault detection steps of the invention based on current operating properties to be applied to such DC transmission networks including a current flow controller.

According to a second aspect of the invention, the invention is defined by a DC transmission network comprising a near-end power converter and at least one far-end power converter interconnected with one another by one or more portions of transmission medium, at least the near-end power converter including a control unit programmed to:

> (a) establish a linear time-invariant model of the transmission medium lying between the or each far-end power converter and the near-end power converter;
> (b) determine a response characteristic of the time-invariant model;
> (c) measure an output operating property of the transmission medium at the near-end power converter;
> (d) identify one far-end power converter as a far-end power converter of interest;
> (e) derive a corresponding input operating property of the transmission medium at the far-end power converter of interest by applying an inverse of the response characteristic of the time-invariant model to the measured output operating property of the transmission medium at the near-end power converter; and
> (f) compare the derived input operating property of the transmission medium at the far-end power converter of interest with a fault characteristic to determine whether there is a fault on the far-end power converter of interest.

The DC transmission network of the invention shares the benefits of the corresponding features of the method of the invention.

There now follows a brief description of preferred embodiments of the invention, by way of non-limiting example, with reference being made to the following figures in which:

> Figure 1(a) shows a schematic view of a DC transmission network according to a first embodiment of the invention;

> Figure 1(b) shows a linear time-invariant model of a transmission medium forming a part of the DC transmission network shown in Figure 1(a);

> Figure 2 illustrates the speed of fault detection possible in the DC transmission network shown in Figure 1(a);

> Figure 3 illustrates the predicted power demanded at a faulty far-end power converter in the DC transmission network shown in Figure 1(a);

> Figure 4(a) shows a schematic view of a DC transmission network according to a second embodiment of the invention;

> Figure 4(b) shows a linear time-invariant model of respective portions of transmission medium forming a part of the DC transmission network shown in Figure 4(a);

> Figure 4(c) shows a linear time-invariant model of respective portions of transmission medium forming a part of a DC transmission network according to a further embodiment of the invention including *N-1* far-end power converters; and

> Figure 5 shows a schematic view of a DC transmission network according to a third embodiment of the invention.

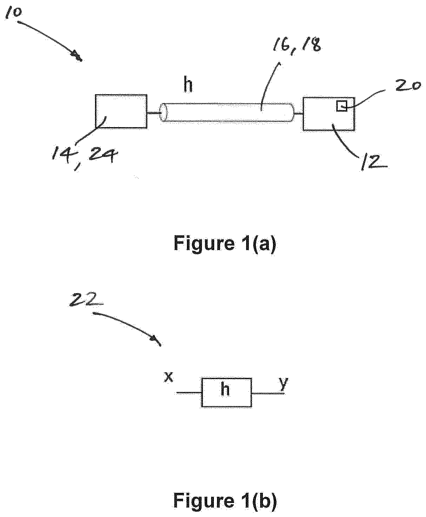

A DC transmission network according to an embodiment of the invention is designated generally by reference numeral 10, as shown in Figure 1(a).

The first DC transmission network 10 includes a near-end power converter 12 and a single far-end power converter 14 which are interconnected with one another by a single, first portion 16 of transmission medium 18, i.e. a single overhead power transmission line or undersea cable. In this manner the first DC transmission network 10 defines a point-to-point DC link. Meanwhile, within the context of the invention, a near-end power converter 12 is a power-converter within the local geographical vicinity of which a control unit is arranged to implement a method of detecting a fault on a geographically remote, i.e. distant, far-end power converter 14.

The near-end power converter 12 includes a control unit 20 that is programmed to:

(a) establish a linear time-invariant model of the transmission medium 18 lying between the far-end power converter 14 and the near-end power converter 12;

(b) determine a response characteristic of the time-invariant model;

(c) measure an output operating property of the transmission medium 18 at the near-end power converter 12;

(d) identify the far-end power converter 14 as a far-end power converter of interest;

(e) derive a corresponding input operating property of the transmission medium 18 at the far-end power converter of interest by applying an inverse of the response characteristic of the time-invariant model to the measured output operating property of the transmission medium 18 at the near-end power converter 12; and

(f) compare the derived input operating property of the transmission medium 18 at the far-end power converter of interest with a fault characteristic to determine whether there is a fault on the far-end power converter of interest.

In other embodiments of the invention, the far-end power converter 14 may also include a control unit that is similarly programmed such that, with respect to the near-end power converter 12, the far-end power converter 14 is itself able to act as a pseudo near-end power converter in order to detect a fault on the geographically distant near-end power converter 12 (that in turn defines a pseudo far-end power converter).

It follows that the control unit 20 of the near-end power converter 12 is programmed to implement a method of detecting a fault on the far-end power converter 14 according to a first embodiment of the invention, i.e. the control unit 20 is programmed to implement a method comprising the steps of:

(a) establishing a linear time-invariant model of the transmission medium 18 lying between the far-end power converter 14 and the near-end power converter 12;

(b) determining a response characteristic of the time-invariant model;

(c) measuring an output operating property of the transmission medium 18 at the near-end power converter 12;

(d) identifying the far-end power converter 14 as a far-end power converter of interest;

(e) deriving a corresponding input operating property of the transmission medium 18 at the far-end power converter of interest by applying an inverse of the response characteristic of the time-invariant model to the measured output operating property of the transmission medium 18 at the near-end power converter 12; and

(f) comparing the derived input operating property of the transmission medium 18 at the far-end power converter of interest with a fault characteristic to determine whether there is a fault on the far-end power converter of interest.

More particularly, step (a) of establishing a time-invariant model of the transmission medium 18 lying between the far-end power converter 14 and the near-end power converter 12, i.e. establishing a model whose response can be used to infer an input operating property $x$ of the transmission medium 18 at the far-end power converter 14 that gave rise to an available measured output operating property $y$ of the transmission medium 18 at the near-end power converter 12, includes establishing a model 22 as shown in Figure 1(b) in which $h$ is a response characteristic of the model 22.

In the embodiment described, step (b) of the method includes determining the response characteristic $h$ of the time-invariant model 22 as an impulse response of the transmission medium 18, although in other embodiments of the invention the response characteristic may instead be a transfer function, differential equation or difference equation which similarly denotes the transformative effect the transmission medium 18 has on an input operating property $x$ at the far-end power converter 14.

In any event the impulse response $h$ or other response characteristic of the time-invariant model 22 can be obtained from experimental results or theoretical analysis of the transmission medium 18, i.e. the single portion 16 of overhead transmission line or undersea transmission cable lying between the near-end power converter 12 and the far-end power converter 14.

In connection with the first method of the invention a step change in voltage is applied to the transmission medium 18 at the far-end power converter 14, i.e. at an input to the time-invariant model 22, and the measured step response is differentiated to give the following voltage impulse response characteristic $h_v(n)$

$$h_v(n) = \begin{cases} A\sin(2\pi f_0 T_s n)e^{-\alpha T_s n} & , \ n \geq 0 \\ 0 & , \ n < 0 \end{cases}$$

where,

the coefficients $A$, $f_0$, $\alpha$ are established by employing a curve fitting technique, and $T_s$ is the sampling time.

Other response characteristics may, however, be determined.

For example, in other embodiments of the invention, a continuous time voltage impulse in the form of a Dirac impulse may instead be applied to the transmission medium at the far-end power converter within a theoretical representation of the first DC transmission network 10, e.g. a computer simulation, to similarly establish an impulse response characteristic.

Thereafter step (c) of the method includes measuring both a first output operating property $y_a$ in the form of a voltage of the transmission medium 18 at the near-end power converter 12, and a second output operating property $y_b$ in the form of a current of the transmission medium 18 at the near-end power converter 12.

The first method of the invention then identifies the single far-end power converter 14 as the far-end power converter of interest 24.

Step (e) of the first method of the invention then includes deriving both a corresponding first input operating property $x_a$ in the form of a voltage of the transmission medium 18 at the far-end power converter 14, and a corresponding second input operating property $x_b$ in the form of a current of the transmission medium 18 at the far-end power converter 14.

More particularly, in considering the inputs $x_a$, $x_b$ and outputs $y_a$, $y_b$ of the time-invariant model 22 shown in Figure 1(b), an output function $y(t)$ is obtained by using a convolution product, i.e. a mathematical operation in which the output function $y(t)$ is a modified version of an input function $x(t)$, defined as

$$y(t) = h(t) * x(t)$$

$$= \int_{-\infty}^{+\infty} h(t-\tau)x(\tau)d\tau$$

$$= \int_{-\infty}^{+\infty} h(\tau)x(t-\tau)d\tau$$

The control unit 20 of the near-end power converter 12 is programmed to operate in conjunction with digital signal processors which sample input data before processing them. Consequently the continuous analogue measured output operating properties $y_a$, $y_b$ of the transmission medium 18 at the near-end power converter 12 are provided in a discrete form and so the above convolution product is similarly reconstituted in a discrete form, i.e.

$$(n) = \sum_{k=-\infty}^{+\infty} h(n-k)x(k)$$

$$= \sum_{k=-\infty}^{+\infty} h(k)x(n-k)$$

where,

$$y(n) \triangleq y(nT_s)$$

with

n being a respective sample; and
$T_s$ being the sample time.

Moreover, since the first DC transmission network 10 is a real system the time-invariant model 22 can only be causal, i.e. its output $y(n)$ can only depend on present and past inputs $x(n)$ and not future inputs. Hence, with respect to the response characteristic $h(n)$,
$h(n) = 0$ for $n < 0$
and so the above discrete convolution product becomes

$$y(n) = \sum_{k=0}^{+\infty} h(k)x(n-k)$$

As indicated above, a voltage impulse response $h_v(n)$, one of many such possible response characteristics that may be used, is established for the first time-invariant model 22 of the form

$$h_v(n) = \begin{cases} A \sin(2\pi f_0 T_s n)e^{-\alpha T_s n} & , \ n \geq 0 \\ 0 & , \ n < 0 \end{cases}$$

In addition to the foregoing, the control unit 20 converts the voltage impulse response $h_v(n)$ into a voltage transfer function $H_v(z)$ in the Z-domain using a Z-transformation to relate a transformed input operating property $X(z)$ and a transformed output operating property $Y(z)$ according to

$$H_v(z) = \frac{Y(z)}{X(z)}$$

which gives

$$H_v(z) = A \frac{e^{-\alpha T_s} \sin(2\pi f_0 T_s)z^{-1}}{1 - 2e^{-\alpha T_s} \cos(2\pi f_0 T_s)z^{-1} + e^{-2\alpha T_s}z^{-2}}$$

It follows that the input operating property $X(z)$ can be derived from a measured output operating property $Y(z)$ by applying an inverse $H_v^{-1}(z)$ of the response characteristic, i.e. the inverse of the voltage transfer function $H_v(z)$, according to

$$X(z) = H_v^{-1}(z)Y(z)$$

where,

$$H_v^{-1}(z) = 1/H_v(z)$$

Accordingly, the control unit 20 is able to derive an estimate of the first input operating voltage $x_a$ of the transmission medium 18 at the far-end power converter 14 by applying the inverse response characteristic $H_v^{-1}(z)$ to the measured first output operating voltage $y_a$ of the transmission medium 18 at the near-end converter 12.

More particularly, the control unit 20 is programmed to generate, using the inverse response characteristic $H_v^{-1}(z)$, a difference equation in the time domain of the following form

$$x_a\ (n) = \frac{1}{A\sin(2\pi f_0 T_s)}[e^{\alpha T_s}y_a(n+1) - 2\cos(2\pi f_0 T_s)y_a(n) + e^{-\alpha T_s}y_a(n-1)]$$

Since the foregoing equation represents a non-causal system, it can be delayed by one sample *n* to represent a causal system

$$x_{a\prime}(n) \triangleq x(n-1)$$

i.e.

$$x_{a\prime}(n) = \frac{1}{A\sin(2\pi f_0 T_s)}[e^{\alpha T_s}y_a(n) - 2\cos(2\pi f_0 T_s)y_a(n-1) + e^{-\alpha T_s}y_a(n-2)]$$

Hence, from respective measured output operating voltage samples $y_a(n)$, $y_a(n-1)$ and $y_a(n-2)$ the input operating voltage $x_{a\prime}$ of the transmission cable 18 at the far-end power converter 14 can be derived.

In addition to the foregoing, the control unit 20 is programmed to implement step (f) of the first method of the invention to compare the derived input operating voltage $x_{a\prime}$ of the transmission medium 18 at the far-end power converter of interest 24 with a fault characteristic to determine whether there is a fault 26 on the far-end power converter of interest 24.

In the embodiment of the method of the invention described herein, the fault characteristic takes the form of a fault threshold, and more particularly a static fault voltage threshold.

In other embodiments of the invention, however, the fault threshold may not be static, i.e. may vary over time, and indeed other fault characteristics such a wave shape or voltage ranges may be used.

Step (f) of the first method of the invention includes predicting whether the derived input operating voltage $x_{a\prime}$ will meet the fault voltage threshold, with such a prediction being realised by considering the rate of change of the derived input operating voltage $x_{a\prime}$.

More particularly the control unit 20 is programmed to predict the input operating voltage $x_{a\prime}$ a number of steps *M* ahead (which preferably is at least one step ahead) by fitting respective derived input operating voltage $x_{a\prime}$ values to a curve using an m-point least-squares estimation technique. Other estimation techniques may, however, also be used.

Such curve fitting is achieved by denoting a curve-fitted vector as $\tilde{x}'(n)$, with

$$\tilde{x}'(n) = a\,n + b$$

and a and b being given by a least-squares estimator which, by way of example, takes the form

$$\begin{bmatrix} a \\ b \end{bmatrix} = [B(k)\,B^{-1}(k)] \cdot B^T(k) \cdot x'(k)$$

in which,

$$B = \begin{bmatrix} k & 1 \\ (k-1) & 1 \\ \vdots & \\ (k-m+1) & 1 \end{bmatrix};$$

and
the observations vector $x'(k)$ is given by

$$x'(k) = \begin{bmatrix} x'(k) \\ x'(k-1) \\ \vdots \\ x'(k-m+1) \end{bmatrix}$$

Accordingly, a predicted input operating voltage $M$ steps ahead is given by

$$\check{x}'(n + M) = a\,(n + M) + b$$

The control unit 20 indicates that there is a fault on the far-end power converter 14 when the predicted input operating voltage $\check{x}'(n + M)$ $M$ steps ahead meets the fault voltage threshold.

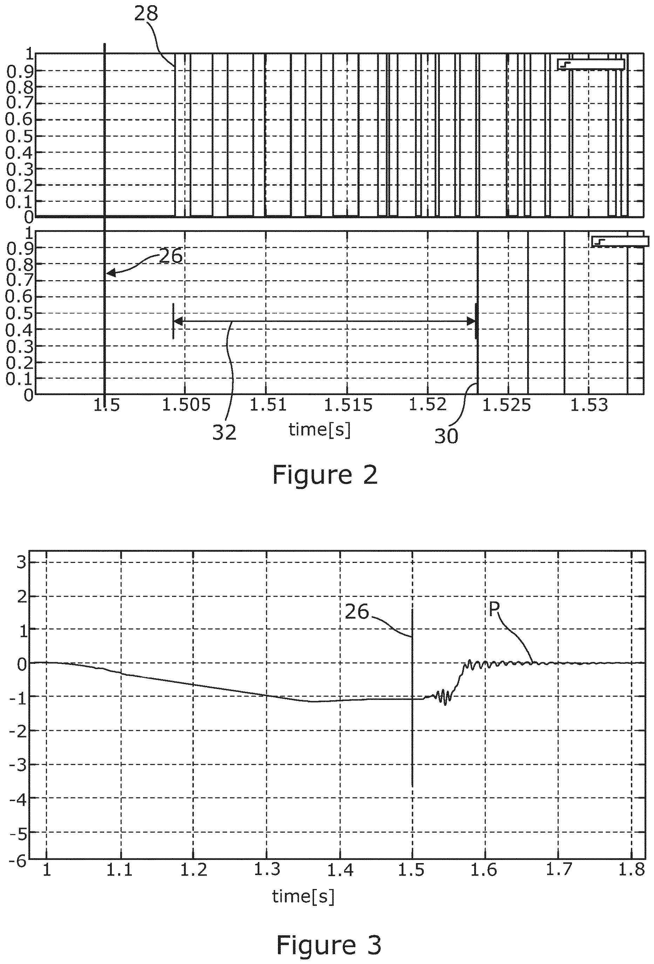

The effectiveness of the first method of the invention is illustrated in Figure 2 which shows that for a single phase fault 26 occurring at the far-end power converter 14 at 1.5 seconds, the predictive approach 28 of the first method of the invention detects the fault 26 at 1.504 seconds, i.e. only 4 milliseconds after the fault 26 occurs, whereas a conventional 90% voltage threshold technique 30 takes a further period 32 of approximately 19 milliseconds to detect the fault 26.

The control unit 20 is similarly programmed to derive an estimate of the second input operating current $x_b$ of the transmission medium 18 at the far-end power converter 14 by applying the inverse response characteristic $H_v^{-1}(z)$ to the measured second output operating current $y_b$ of the transmission medium 18 at the near-end converter 12.

From such derived estimates of the first and second input operating voltage $x_a$ and current $x_b$ the control unit 20 estimates the power P in the transmission medium 18 at the far-end power converter of interest 24 by multiplying the said estimated first and second input operating voltage $x_a$ and current $x_b$.

This allows, as shown in Figure 3, the estimated power P to be used as a power reference on the healthy side of the far-end power converter 14 to allow the fault 26 to be ridden through without collapsing the voltage of the transmission medium 18.

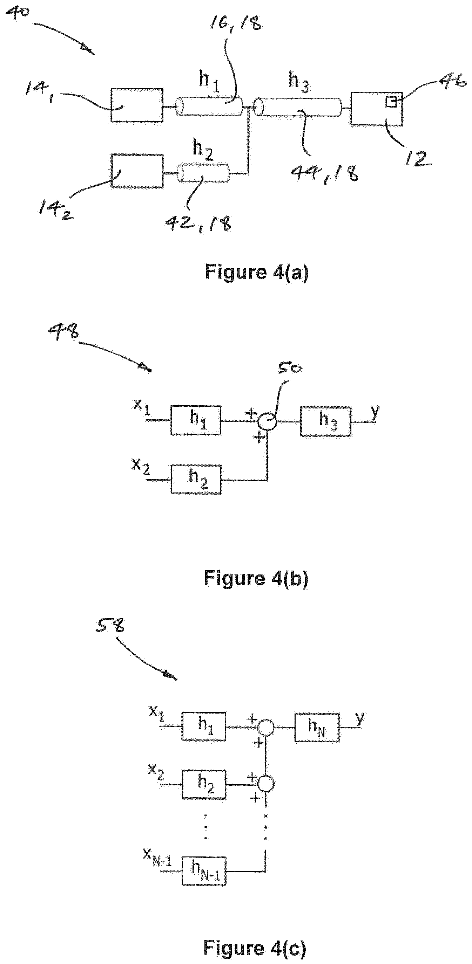

A DC transmission network 40 according to a further embodiment of the invention is shown schematically in Figure 4(a).

The second DC transmission network 40 includes a near-end power converter 12 and two far-end power converters 14 and in this manner defines a multi-terminal DC link. The power converters 12, 14 are shown interconnected with one another by first, second and third portions 16, 42, 44 of transmission medium 18 in a star topology. The arrangement of the power converters 12, 14 and interconnecting transmission medium 18 in the second DC transmission network 40 may actually define a different topology, such as a delta topology.

The star topology shown in Figure 4(a) is just one way in which the transmission medium 18 arrangement in the actual second DC transmission network 40 may be represented, and other topologies may instead be used to represent the transmission medium 18 arrangement.

In a similar manner to the first DC transmission network 10, the near-end power converter 12 in the second DC transmission network 40 includes a control unit 46. The second control unit 46 is, however, programmed differently to the first control unit 20.

More particularly the second control unit 46 is programmed to:

(a) establish a linear time-invariant model of the transmission medium 18 lying between the two far-end power converters 14 and the near-end power converter 12;

(b) determine a response characteristic of the time-invariant model;

(c) measure an output operating property of the transmission medium 18 at the near-end power converter 12;

(d) identify one far-end power converter 14 as a far-end power converter of interest;

(e) derive a corresponding input operating property of the transmission medium 18 at the far-end power converter of interest by applying an inverse of the response characteristic of the time-invariant model to the measured output operating property of the transmission medium 18 at the near-end power converter 12; and

(f) compare the derived input operating property of the transmission medium 18 at the far-end power converter of interest with a fault characteristic to determine whether there is a fault on the far-end power converter of interest.

In other embodiments of the invention, one or both of the far-end power converters 14 may also include a second control unit so that each is itself able to act as a pseudo near-end power converter in order to detect a fault on one of the other power converters.

The second control unit 46 of the near-end power converter 12 in the second DC transmission network 40 is accordingly programmed to implement a method of detecting a fault on a far-end power converter of interest according to a second embodiment of the invention.

The second control unit 46 is so programmed to implement a second method comprising the steps of:

(a) establishing a linear time-invariant model of the transmission medium 18 lying between the far-end power converters 14 and the near-end power converter 12;

(b) determining a response characteristic of the time-invariant model;

(c) measuring an output operating property of the transmission medium 18 at the near-end power converter 12;

(d) identifying one far-end power converter 14 as a far-end power converter of interest;

(e) deriving a corresponding input operating property of the transmission medium 18 at the far-end power converter of interest by applying an inverse of the response characteristic of the time-invariant model to the measured output operating property of the transmission medium 18 at the near-end power converter 12; and

(f) comparing the derived input operating property of the transmission medium 18 at the far-end power converter of interest with a fault characteristic to determine whether there is a fault on the far-end power converter of interest.

Step (a) of establishing a time-invariant model of the transmission medium 18 lying between the far-end power converters 14 and the near-end power converter 12 includes establishing a model 48 as shown in Figure 4(b).

The overall response characteristic of such a time-invariant model 48 is given by

$$y(n) = h_3(n) * [x_1(n) * h_1(n) + x_2(n) * h_2(n)]$$

where,

$h_1$ is an individual response characteristic of the first portion 16 of transmission medium lying between one far-end power converter 14 and a star junction 50;

$h_2$ is an individual response characteristic of the second portion 42 of transmission medium lying between the other far-end power converter 14 and the star junction 50; and

$h_3$ is an individual response characteristic of the third portion 44 of transmission medium lying between the near-end power converter 14 and the star junction 50, with each of the individual response characteristics $h_1$, $h_2$, $h_3$ taking the form of a voltage impulse response, i.e.

$$h_v(n) = \begin{cases} A\sin(2\pi f_0 T_s n)e^{-\alpha T_s n} & , \ n \geq 0 \\ 0 & , \ n < 0 \end{cases}$$

where,
the coefficients $A$, $f_0$, $\alpha$ are established by employing a curve fitting technique, and $T_s$ is the sampling time.

Other response characteristics may be used however.

Meanwhile step (c) of the second method includes measuring the output operating voltage y of the transmission medium 18 at the near-end power converter 12.

In the meantime, step (d) of identifying one of the far-end power converter 14 as the far-end power converter of interest 24 includes testing a respective hypothesis for each far-end power converter 14 that a fault has occurred at the given far-end power converter 14 while the other far-end power converter 14 continues to operate normally.

More particularly, testing a respective hypothesis for each far-end power converter 14 includes:

ascribing an estimated fault level input operating voltage $x_{STEP}$ of the transmission medium 18 at the given far-end power converter 14 at which the fault is postulated to have occurred;

utilising a known previous input operating voltage $x_{1_{OP}}$, $x_{2_{OP}}$ of the transmission medium at the other far-end power converter 14; and

applying the overall response characteristic of the time-invariant model 48 to the estimated fault level input operating voltage $x_{STEP}$ of the transmission medium 18 at the given far-end power converter 14 at which the fault is postulated to have occurred and to the known previous input operating voltage $x_{1_{OP}}$, $x_{2_{OP}}$ of the transmission medium 18 at the or each other far-end power converter 14 to obtain an expected theoretical output operating voltage $\hat{y}^{(1)}(n)$, $\hat{y}^{(2)}(n)$ of the transmission medium 18 at the near-end power converter 12.

In other words:

(i) according to a first hypothesis the fault occurred at a first far-end power converter $14_1$, and so the estimated fault level input operating voltage $x_{STEP}$ is considered to be the input operating voltage $\hat{x}_1^{(1)}(n)$ of the transmission medium 18 at the said first far-end power converter $14_1$, i.e.

$$\hat{x}_1^{(1)}(n) = x_{STEP}$$

while the known previous input operating voltage $x_{2_{OP}}$ of the other, i.e. a second far-end power converter $14_2$, is utilised as the input operating voltage $\hat{x}_2^{(1)}(n)$ of the other, second far-end power converter $14_2$, i.e.

$$\hat{x}_2^{(1)}(n) = x_{2_{OP}}$$

such that when the overall response characteristic of the time-invariant model 48 is applied the expected theoretical output operating voltage $\hat{y}^{(1)}(n)$ is given by

$$\hat{y}^{(1)}(n) = h_3(n) * [\hat{x}_1^{(1)}(n) * h_1(n) + \hat{x}_2^{(1)}(n) * h_2(n)];$$

and

(ii) according to a second hypothesis the fault occurred at the second far-end power converter $14_2$, and so the estimated fault level input operating voltage $x_{STEP}$ is considered to be the input operating voltage $\hat{x}_2^{(2)}(n)$ of the transmission medium 18 at the said second far-end power converter $14_2$, i.e.

$$\hat{x}_2^{(2)}(n) = x_{STEP}$$

while the known previous input operating voltage $x_{1_{OP}}$ of the other, i.e. the first far-end power converter $14_1$, is utilised as the input operating voltage $\hat{x}_1^{(2)}(n)$ of the other, first far-end power converter $14_1$, i.e.

$$\hat{x}_1^{(2)}(n) = x_{1_{OP}}$$

such that when the overall response characteristic of the time-invariant model 48 is applied the expected theoretical output operating voltage $\hat{y}^{(2)}(n)$ is given by

$$\hat{y}^{(2)}(n) = h_3(n) * [\hat{x}_1^{(2)}(n) * h_1(n) + \hat{x}_2^{(2)}(n) * h_2(n)]$$

Thereafter, testing a respective hypothesis for each far-end power converter 14 includes comparing the expected theoretical output operating voltage $\hat{y}^{(1)}(n)$, $\hat{y}^{(2)}(n)$ of the transmission medium 18 at the near-end power converter 12 established under the associated hypothesis with the actual measured output operating voltage y of the transmission medium 18 at the near-end power converter 12.

More particularly, the far-end power converter $14_1$, $14_2$ identified as the far-end power converter of interest is the power converter $14_1$, $14_2$ whose respective hypothesis results in the corresponding expected theoretical output operating voltage $\hat{y}^{(1)}(n)$, $\hat{y}^{(2)}(n)$ most closely matching the measured output operating voltage y of the transmission medium 18 at the near-end power converter 12.

One way in which the most closely matching hypothesis may be identified is to select the first hypothesis, i.e. consider the fault to be at the first far-end power converter $14_1$ (such that the first far-end power converter $14_1$ is identified as the far-end power converter of interest) if

$$\sum_{n=0}^{L-1} \left| \hat{y}^{(1)}(n) - y(n) \right| < \sum_{n=0}^{L-1} \left| \hat{y}^{(2)}(n) - y(n) \right|$$

or otherwise select the second hypothesis (and thereby identify the second far-end power converter $14_2$ as the far-end power converter of interest).

In the comparative equation shown above L is the length of the data vector chosen based on a tolerable delay introduced by the decision logic, i.e. is the number of consecutive iterations of the comparison carried out before a final decision is taken.

In other embodiments of the invention respective expected theoretical output operating currents may instead be calculated and compared with measured output operating currents in order to identify a single far-end power converter $14_1$, $14_2$ as the far-end power converter of interest.

In any event, once a far-end converter of interest has been identified, step (e) of the second method of the invention is carried out to derive the actual estimated input operating voltage $\hat{x}_1(n)$, $\hat{x}_2(n)$ of the transmission medium 18 at the said far-end power converter of interest to replace the previously utilised estimated fault level input operating voltage $x_{STEP}$.

The overall response characteristic of the time-invariant model 48, i.e.

$$y(n) = h_3(n) * [x_1(n) * h_1(n) + x_2(n) * h_2(n)]$$

is, in a similar manner to the first method of the invention, again used for this step with the input operating voltage $\hat{x}_1(n)$, $\hat{x}_2(n)$ of the transmission medium 18 at the other far-end power converter being taken as the corresponding known previous input operating voltage $x_{1_{OP}}$, $x_{2_{OP}}$, such that rearrangement of the above-equation, i.e. applying an inverse of the overall response characteristic, allows the actual corresponding estimated input operating voltage $\hat{x}_1(n)$, $\hat{x}_2(n)$ of the transmission medium 18 at the said far-end power converter of interest to be derived.

Such actual corresponding estimated input operating voltage $\hat{x}_1(n)$, $\hat{x}_2(n)$ of the transmission medium 18 at the said far-end power converter of interest is then compared with a fault voltage threshold in a similar manner, i.e. a predictive manner, to that set out in connection with the first method of the invention. The actual corresponding estimated input operating voltage $\hat{x}_1(n)$, $\hat{x}_2(n)$ of the transmission medium 18 at the said far-end power converter of interest may, in other embodiments of the invention, be compared with some other fault characteristic in order to determine whether there is a fault on the far-end power converter of interest.

In addition, in a similar manner an estimated input operating current may instead be derived and compared with a fault current threshold, and if both estimated input voltage and current values are derived then the power at the far-end power converter of interest may also be estimated.

Furthermore the second method of the invention may be generalised to cover multi-terminal DC transmission networks which have N-1 power converters 12, 14.

In such a generalised second method of the invention, establishing a linear time-invariant model includes establishing a third time-invariant model 58, as shown in Figure 4(c).

Meanwhile, determining an overall response characteristic of the third time-invariant model 58 gives rise to

$$y(n) = h_N(n) * \sum_{i=1}^{N-1} x_i(n) * h_i(n)$$

where the individual response characteristic $h_1 \ldots h_N$ of each respective portion of transmission medium is known.

Thereafter, generalising a hypothesis for each far-end power converter 14 that it might be at fault leads to:

- Hypothesis 1: the fault occurred at a first far-end power converter $14_1$. Then

$$\hat{x}_1^{(1)}(n) = x_{STEP}$$

$$\hat{x}_j^{(N-1)}(n) = x_{j_{OP}},$$

$j = 2,3\ldots,N-1$ with each previous input operating property being known.
- Hypothesis 2: the fault occurred at a second far-end power converter $14_2$.

Then

.

.

.

- Hypothesis N-1: the fault occurred at far-end power converter $14_{N-1}$. Then

$$\hat{x}_{N-1}^{(N-1)}(n) = x_{STEP}$$

$$\hat{x}_j^{(N-1)}(n) = x_{j_{OP}} \quad,$$

$j = 1,2,\ldots,N-2$

In general, all the hypotheses can be expressed into the following closed form:
For each k = 1,2,...,N - 1, state the following:
Hypothesis k: the fault occurred at far-end power converter $14_k$. Then

$$\hat{x}_k^{(k)}(n) = x_{STEP}$$

$$\hat{x}_j^{(k)}(n) = x_{j_{OP}},$$

$j = 1,2,\ldots,N-1, j \neq k$

Combining this with the overall response characteristic of the third time-invariant model 58, to allow respective expected theoretical output operating properties $\hat{y}^{(q)}(n)$ to be obtained, gives

$$\hat{y}^{(k)}(n) = h_N(n) * \sum_{\substack{i=1 \\ i \neq k}}^{N-1} \hat{x}_i^{(k)}(n) * h_i(n)$$

such that the hypothesis $q$ which gives rise to the closes match between the theoretical output operating property $\hat{y}^{(q)}(n)$ and the actual measured output operating property $y(n)$ can be determined by

$$\sum_{i=1}^{L} |\hat{y}^{(q)}(n) - y(n)| = \min_{k} \sum_{i=1}^{L} |\hat{y}^{(k)}(n) - y(n)| \quad ,$$

$q,k$ = 1,2, ...,$N$ - 1

Where $q$ is the particular value of $k$ that minimises $|\hat{y}^{(k)}(n) - y(n)|$ over $L$ consecutive samples and for all possible values of $k$.

In addition, the estimated fault level input operating voltage $\hat{x}_q$, i.e. $x_{STEP}$, can be further refined by deriving its expression from the measured output operating properties $y(n)$ and employing

$$y(n) = h_N(n) * \sum_{i=1}^{N-1} x_i(n) * h_i(n)$$

for the case $\hat{x}_j^{(k)} = x_{j_{OP}}$ , with $j$ = 1,2,...,$N$ - 1, and $j \neq q$.

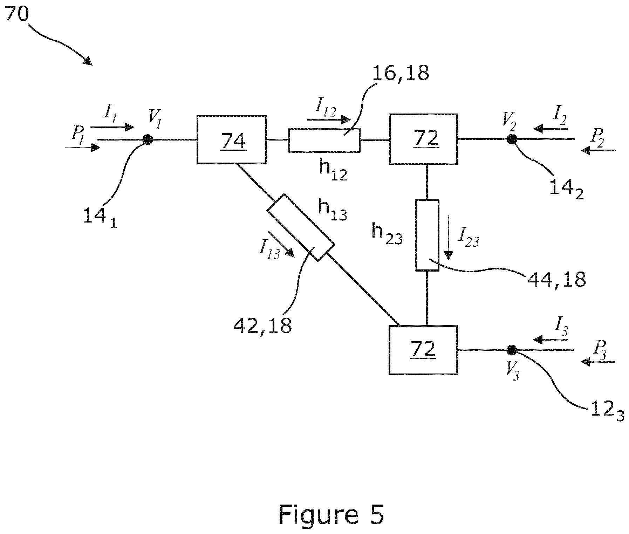

A DC transmission network 70 according to a further embodiment of the invention is shown schematically in Figure 5.

The third DC transmission network 70 is similar to the DC transmission network 40 shown in Figure 4(a) and like features share the same reference numerals. To that end the third DC transmission network 70 includes a near-end power converter $12_3$ and two far-end power converters $14_1$, $14_2$ and in this manner similarly defines a multi-terminal DC link.

The power converters $12_3$, $14_1$, $14_2$ are mutually interconnected with one another by first, second and third portions 16, 42, 44 of transmission medium 18 that are mechanically and electrically connected to one another at respective connection points 72.

The third DC transmission network 70 also includes a current flow controller 74 which balances internal currents $I_{12}, I_{13}, I_{23}$ that flow between the said power converters $12_3$, $14_1$, $14_2$. More particularly, the current flow controller 74 appreciably alters the internal currents $I_{12}, I_{13}, I_{23}$ by modifying the voltage across each portion 16, 42, 44 of transmission medium 18.

Each said portion 16, 42, 44 of transmission medium 18 has a corresponding individual response characteristic $h_{12}, h_{13}, h_{23}$, which preferably is (as is the case in association with the first and second methods of the invention) an individual voltage impulse response of the form

$$h_v(n) = \begin{cases} A \sin(2\pi f_0 T_s n) e^{-\alpha T_s n} & , \ n \geq 0 \\ 0 & , \ n < 0 \end{cases}$$

The current flow controller 74 does not produce a noticeable change in the voltage of the various transmission medium portions 16, 42, 44. Therefore, with respect to the measurement of an output operating *voltage* of the transmission medium 18 at the near-end power converter $12_3$ and the subsequent derivation of a corresponding input operating *voltage* of the transmission medium 18 at a given far-end power converter $14_1$, $14_2$ of interest, the second method of the invention described hereinabove can be applied to the third DC transmission network 70 in order to detect a fault at one or other of the far-end power converters $14_1$, $14_2$, i.e. by making use of a first overall response characteristic (which in turn is determined in part using the Superposition Principle) of the form

$$y_3(n) = h_{13}(n) * x_1(n) + h_{23}(n) * x_2(n)$$

In contrast, when wishing to measure an output operating *current* of the transmission medium 18 at the near-end power converter $12_3$ and subsequently derive a corresponding input operating *current* of the transmission medium 18 at a given far-end power converter $14_1$, $14_2$ of interest, it is necessary to factor in the distribution of circulating internal currents $I_{12}, I_{13}$ (and consequently $I_{23}$) since the current flow controller 74 varies these while leaving the terminal current

$I_1, I_2, I_3$ at each power converter $12_3$, $14_1$, $14_2$ unchanged.

Consequently, a method according to a third embodiment of the invention of detecting a fault in the third DC transmission network 70 is similar to the second method of the invention but additionally factors in the distribution of internal currents $I_{12}, I_{13}, I_{23}$ amongst the said power converters $12_3$, $14_1$, $14_2$ by including a weighting coefficient corresponding to each internal current flow $I_{12}, I_{13}, I_{23}$ between respective pairs of mutually interconnected power converters $12_3$, $14_1$, $14_2$.

More particularly, in the third method of the invention a first weighting coefficient $a_{12}$ is applied to the first transmission medium portion 16 having a first individual response characteristic $h_{12}$, a second weighting coefficient $a_{13}$ is applied to the second transmission medium portion 42 having a second individual response characteristic $h_{13}$, and a third weighting coefficient $a_{23}$ is applied to the third transmission medium portion 44 having a third individual response characteristic $h_{23}$.

The respective weighting coefficients $a_{12}, a_{13}, a_{23}$ sum to 1 and each is known by all of the power converters $12_3$, $14_1$, $14_2$.

Consequently, with respect to the near-end power converter $12_3$, the measured output operating current $I_3$ is given by the sum of the terminal currents $I_1, I_2$ at the two far-end power converters $14_1$, $14_2$ such that a second, current-based, overall response characteristic is given by

$$y_3(n) = \tilde{h}_{13}(n) * x_1(n) + \tilde{h}_{23}(n) * x_2(n)$$

where,

$y_3 = I_3$;
$x_1 = I_1$; and
$x_2 = I_2$

and

$\tilde{h}_{13}$ is given by
$f_1(h_{12}, h_{13}, h_{23}, a_{12}, a_{13}, a_{23}) \rfloor x_2 = 0$ ; and
$\tilde{h}_{23}$ is given by
$f_2(h_{12}, h_{13}, h_{23}, a_{12}, a_{13}, a_{23}) \rfloor x_1 = 0$

i.e. the expressions $\tilde{h}_{13}$ and $\tilde{h}_{23}$ are themselves given by respective time-invariant functions $f_1$ and $f_2$ such that subsequent steps essentially identical to those in the second method of the invention can then be utilised in the third method of the invention to detect a fault at one or other of the far-end power converters $14_1$, $14_2$ in the third DC transmission network 70 by making use of measured and derived current operating properties and the second overall response characteristic, i.e.

$$y_3(n) = \tilde{h}_{13}(n) * x_1(n) + \tilde{h}_{23}(n) * x_2(n)$$

as set out hereinabove.

**Claims**

1.  A method of detecting a fault (26) on a far-end power converter (14; $14_1$, $14_2$) within a DC transmission network (10, 40, 70) comprising a near-end power converter (12, $12_3$) and at least one far-end power converter (14; $14_1$, $14_2$) interconnected with one another by one or more portions (16, 42, 44) of transmission medium (18), the method comprising the steps of:

    (a) establishing a linear time-invariant model (22; 48; 58) of the transmission medium (18) lying between the or each far-end power converter (14; $14_1$, $14_2$) and the near-end power converter (12; $12_3$);
    (b) determining a response characteristic of the time-invariant model (22; 48; 58);
    (c) measuring an output operating property ($y_a$, $y_b$) of the transmission medium (18) at the near-end power converter (12, $12_3$);
    (d) identifying one far-end power converter (14; $14_1$, $14_2$) as a far-end power converter of interest (24);

(e) deriving a corresponding input operating property ($x_a$, $x_b$) of the transmission medium (18) at the far-end power converter of interest (24) by applying an inverse of the response characteristic of the time-invariant model (22; 48; 58) to the measured output operating property ($y_a$, $y_b$) of the transmission medium (18) at the near-end power converter (12; $12_3$); and

(f) comparing the derived input operating property ($x_a$, $x_b$) of the transmission medium (18) at the far-end power converter of interest (24) with a fault characteristic to determine whether there is a fault on the far-end power converter of interest (24).

2. A method according to Claim 1, wherein step (f) of comparing the derived input operating property ($x_a$, $x_b$) of the transmission medium (18) at the far-end power converter of interest (24) with a fault characteristic to determine whether there is a fault (26) on the far-end power converter of interest (24) includes predicting whether the derived input operating property ($x_a$, $x_b$) will meet the fault characteristic and indicating that there is a fault (26) on the far-end power converter of interest (24) when the derived input operating property ($x_a$, $x_b$) is predicted to meet the fault characteristic.

3. A method according to Claim 2, wherein predicting whether the derived input operating property ($x_a$, $x_b$) will meet the fault characteristic includes determining an expected output operating property at least one step ahead.

4. A method according to any preceding claim, wherein step (b) of determining a response characteristic of the time-invariant model (22; 48; 58) includes establishing one or more of the following to describe the transformative effect the one or more portions of transmission medium (18) has on the input operating property ($x_a$, $x_b$) at the or each far-end power converter (14; $14_1$, $14_2$):

an impulse response;
a transfer function;
a differential equation; and
a difference equation.

5. A method according to any preceding claim, including:
measuring one or both of a first output operating property ($y_a$) in the form of a voltage of the transmission medium (18) at the near-end power converter (12; $12_3$), and a second output operating property ($Y_b$) in the form of a current of the transmission medium (18) at the near-end power converter (12; $12_3$); and
deriving one or both of a corresponding first input operating property ($x_a$) in the form of a voltage of the transmission medium (18) at the far-end power converter of interest (24), and a corresponding second input operating property ($x_b$) in the form of a current of the transmission medium (18) at the far-end power converter of interest (24).

6. A method according to Claim 5, wherein both voltage and current output operating properties ($y_a$, $y_b$) are measured and subsequently both corresponding voltage and current input operating properties ($x_a$, $x_b$) are derived, additionally includes the step of estimating the power at the far-end power converter of interest (24) from the said derived voltage and current input operating properties ($x_a$, $x_b$).

7. A method according to any preceding claim, of detecting a fault (26) on a far-end power converter (14; $14_1$, $14_2$), within a DC transmission network (10, 40, 70) including the near-end power converter (12; $12_3$) and a plurality of far-end power converters (14; $14_1$, $14_2$), wherein step (d) of identifying one far-end power converter (14; $14_1$, $14_2$) as a far-end power converter of interest (24) includes testing a respective hypothesis for each far-end power converter (14; $14_1$, $14_2$) that a fault has occurred at the given far-end power converter (14; $14_1$, $14_2$) and the or each other far-end power converter (14; $14_1$, $14_2$) continues to operate normally.

8. A method according to Claim 7, wherein the step of testing a respective hypothesis for each far-end power converter (14; $14_1$, $14_2$) includes:

ascribing an estimated fault level input operating property of the transmission medium (18) at the given far-end power converter at which the fault (26) is postulated to have occurred;
utilising a known previous input operating property ($x_a$, $x_b$) of the transmission medium (18) at the or each other far-end power converter (14; $14_1$, $14_2$);
applying the response characteristic of the time-invariant model (22; 48; 58) to the estimated fault level input operating property ($x_a$, $x_b$) of the transmission medium (18) at the given far-end power converter (14; $14_1$, $14_2$) at which the fault is postulated to have occurred and to the known previous input operating property of the

## EP 3 440 473 B1

transmission medium at the or each other far-end power converter (14; $14_1$, $14_2$); to obtain an expected theoretical output operating property of the transmission medium at the near-end power converter (12; $12_3$); and comparing the expected theoretical output operating property of the transmission medium (18) at the near-end power converter (12; $12_3$) with the measured output operating property of the transmission medium (18) at the near-end power converter (12; $12_3$).

9. A method according to Claim 8, wherein the far-end power converter (14; $14_1$, $14_2$) identified as the far-end power converter of interest (24) is the power converter whose respective hypothesis results in the corresponding expected theoretical output operating property most closely matching the measured output operating property of the transmission medium (18).

10. A method according to any preceding claim, including the near-end power converter (12; $12_3$), a plurality of far-end power converters (14, $14_2$) and a current flow controller to balance internal currents flowing between the power converters (12, 14, $14_2$) which are mutually interconnected with one another, wherein a current output operating property is measured at the near-end power converter (12; $12_3$) and the response characteristic of the time-invariant model additionally factors in the distribution of internal currents amongst the said power converters (12, $12_3$, $14_1$, $14_2$).

11. A method according to Claim 10, wherein the response characteristic additionally factors in the distribution of internal currents amongst the said power converters by including a weighting coefficient corresponding to each internal current flow between respective pairs of mutually interconnected power converters.

12. A DC transmission network comprising a near-end power converter (12; $12_3$) and at least one far-end power converter (14; $14_1$, $14_2$) interconnected with one another by one or more portions (16, 42, 44) of transmission medium (18), at least the near-end power converter (12; $12_3$) including a control unit programmed to:

(a) establish a linear time-invariant model (22; 48; 58) of the transmission medium (18) lying between the or each far-end power converter (14; $14_1$, $14_2$) and the near-end power converter (12; $12_3$);
(b) determine a response characteristic of the time-invariant model (22; 48; 58);
(c) measure an output operating property ($y_a$, $y_b$) of the transmission medium (18) at the near-end power converter (12; $12_3$);
(d) identify one far-end power converter (14; $14_1$, $14_2$) as a far-end power converter of interest (24);
(e) derive a corresponding input operating property ($x_a$, $x_b$) of the transmission medium (18) at the far-end power converter (24) of interest by applying an inverse of the response characteristic of the time-invariant model (22; 48; 58) to the measured output operating property ($y_a$, $y_b$) of the transmission medium (18) at the near-end power converter (12; $12_3$); and
(f) compare the derived input operating property ($x_a$, $x_b$) of the transmission medium (18) at the far-end power converter of interest (24) with a fault characteristic to determine whether there is a fault on the far-end power converter of interest (24).

**Patentansprüche**

1. Verfahren zur Erkennung eines Fehlers (26) an einem hinteren Leistungswandler (14; $14_1$, $14_2$) innerhalb eines Gleichstromübertragungsnetzwerks (10, 40, 70), das einen vorderen Leistungswandler (12, $12_3$) und mindestens einen hinteren Leistungswandler (14; $14_1$, $14_2$) umfasst, die miteinander durch einen oder mehrere Abschnitte (16, 42, 44) von Übertragungsmedium (18) verschaltet sind, das Verfahren umfassend die Schritte:

a) Einrichten eines linearen zeitunveränderlichen Modells (22; 48; 58) des Übertragungsmediums (18), das zwischen dem oder jedem hinteren Leistungswandler (14; $14_1$, $14_2$) und dem nahen Leistungswandler (12; $12_3$) liegt;
b) Bestimmen einer Antwortcharakteristik des zeitunveränderlichen Modells (22, 48; 58);
c) Messen einer Ausgabebetriebseigenschaft ($y_a$, $y_b$) des Übertragungsmediums (18) bei dem vorderen Leistungswandler (12, $12_3$);
d) Identifizieren eines hinteren Leistungswandlers (14; $14_1$, $14_2$) als einen hinteren Leistungswandler von Interesse (24);
e) Ableiten einer entsprechenden Eingabebetriebseigenschaft ($x_a$, $x_b$) des Übertragungsmediums (18) bei dem hinteren Leistungswandler von Interesse (24) durch Anwenden einer Umkehr der Antwortcharakteristik des zeitunveränderlichen Modells (22; 48; 58) auf die gemessene Ausgabebetriebseigenschaft ($y_a$, $y_b$) des Über-

tragungsmediums (18) bei dem vorderen Leistungswandler (12; 12₃); und

f) Vergleichen der abgeleiteten Eingabebetriebseigenschaft ($x_a$, $x_b$) des Übertragungsmediums (18) bei dem hinteren Leistungswandler von Interesse (24) mit einer Fehlercharakteristik, um zu bestimmen, ob es einen Fehler auf dem hinteren Leistungswandler von Interesse (24) gibt.

2. Verfahren nach Anspruch 1, wobei Schritt (f) zum Vergleichen der abgeleiteten Eingabebetriebseigenschaft ($x_a$, $x_b$) des Übertragungsmediums (18) bei dem hinteren Leistungswandler von Interesse (24) mit einer Fehlercharakteristik, um zu bestimmen, ob es einen Fehler (26) an dem hinteren Leistungswandler von Interesse (24) gibt, Vorhersagen beinhaltet, ob die abgeleitete Eingabebetriebseigenschaft ($x_a$, $x_b$) die Fehlercharakteristik erfüllen wird, und Angeben, ob es einen Fehler (26) an dem hinteren Leistungswandler von Interesse (24) gibt, wenn die abgeleitete Eingabebetriebseigenschaft ($x_a$, $x_b$) vorhergesagt ist, die Fehlercharakteristik zu erfüllen.

3. Verfahren nach Anspruch 2, wobei Vorhersagen, ob die abgeleitete Eingabebetriebseigenschaft ($x_a$, $x_b$) die Fehlercharakteristik erfüllen wird, Bestimmen einer erwarteten Ausgabebetriebseigenschaft mindestens einen Schritt voraus beinhaltet.

4. Verfahren nach einem der vorstehenden Ansprüche, wobei Schritt b) zum Bestimmen einer Antwortcharakteristik des zeitunveränderlichen Modells (22; 48; 58) Einrichten eines oder mehrerer der Folgenden beinhaltet, um die transformative Wirkung zu beschreiben, die der eine oder die mehreren Abschnitte von Übertragungsmedium (18) auf die Eingabebetriebseigenschaft ($x_a$, $x_b$) bei dem oder jedem hinteren Leistungswandler (14; 14₁, 14₂) hat:

einer Impulsantwort;
einer Transferfunktion;
einer Differentialgleichung; und
einer Unterschiedsgleichung.

5. Verfahren nach einem der vorstehenden Ansprüche, beinhaltend:

Messen einer oder beider einer ersten Ausgabebetriebseigenschaft ($y_a$) in der Form einer Spannung des Übertragungsmediums (18) bei dem vorderen Leistungswandler (12; 12₃) und einer zweiten Ausgabebetriebseigenschaft ($y_b$) in der Form eines Stroms des Übertragungsmediums (18) bei dem vorderen Leistungswandler (12; 12₃); und
Ableiten einer oder beider einer entsprechenden ersten Eingabebetriebseigenschaft ($x_a$) in der Form einer Spannung des Übertragungsmediums (18) bei dem hinteren Leistungswandler von Interesse (24) und einer entsprechenden zweiten Eingabebetriebseigenschaft ($x_b$) in der Form eines Stroms des Übertragungsmediums (18) bei dem hinteren Leistungswandler von Interesse (24).

6. Verfahren nach Anspruch 5, wobei sowohl Spannungs- als auch Stromausgabebetriebseigenschaften ($y_a$, $y_b$) gemessen sind und nachfolgend sowohl die entsprechenden Spannungs- als auch Stromeingabebetriebseigenschaften ($x_a$, $x_b$) abgeleitet sind, das zusätzlich den Schritt zum Schätzen der Leistung bei dem hinteren Leistungswandler von Interesse (24) aus den abgeleiteten Spannungs- und Stromeingabebetriebseigenschaften ($x_a$, $x_b$) beinhaltet.

7. Verfahren nach einem der vorstehenden Ansprüche zum Erkennen eines Fehlers (26) an einem hinteren Leistungswandler (14; 14₁, 14₂) innerhalb eines Gleichstromübertragungsnetzwerks (10, 40, 70), beinhaltend den hinteren Leistungswandler (12; 12₃) und eine Vielzahl von hinteren Leistungswandlern (14; 14₁, 14₂), wobei Schritt d) zum Identifizieren eines hinteren Leistungswandlers (14; 14₁, 14₂) als einen hinteren Leistungswandler von Interesse (24) Testen einer jeweiligen Hypothese für jeden hinteren Leistungswandler (14; 14₁, 14₂) beinhaltet, dass ein Fehler bei dem gegebenen hinteren Leistungswandler (14; 14₁, 14₂) aufgetreten ist, und der oder jeder andere hintere Leistungswandler (14; 14₁, 14₂) Normalbetrieb fortsetzt.

8. Verfahren nach Anspruch 7, wobei der Schritt zum Testen einer jeweiligen Hypothese für jeden hinteren Leistungswandler (14; 14₁, 14₂) beinhaltet:

Zuschreiben einer geschätzten Fehlerstufeneingabebetriebseigenschaft des Übertragungsmediums (18) bei dem gegebenen hinteren Leistungswandler, bei dem ein Auftreten des Fehlers (26) vorausgesetzt wird;
Nutzen einer bekannten vorigen Eingabebetriebseigenschaft ($x_a$, $x_b$) des Übertragungsmediums (18) bei dem oder jedem anderen hinteren Leistungswandler (14; 14₁, 14₂);
Anwenden der Antwortcharakteristik des zeitunveränderlichen Modells (22; 48; 58) auf die geschätzte Fehlerstu-

feneingabebetriebseigenschaft ($x_a$, $x_b$) des Übertragungsmediums (18) bei dem gegebenen hinteren Leistungswandler (14; $14_1$, $14_2$), bei dem ein Auftreten des Fehlers vorausgesetzt wird, und auf die bekannte vorige Eingabebetriebseigenschaft des Übertragungsmediums bei dem oder jedem anderen hinteren Leistungswandler (14; $14_1$, $14_2$); um eine erwartete theoretische Betriebseigenschaft des Übertragungsmediums bei dem vorderen Leistungswandler (12; $12_3$) zu erhalten; und

Vergleichen der erwarteten theoretischen Ausgabebetriebseigenschaft des Übertragungsmediums (18) bei dem nahen Leistungswandler (12; $12_3$) mit der gemessenen Ausgabebetriebseigenschaft des Übertragungsmediums (18) bei dem nahen Leistungswandler (12; $12_3$).

**9.** Verfahren nach Anspruch 8, wobei der hintere Leistungswandler (14; $14_1$, $14_2$), der als der hintere Leistungswandler von Interesse (24) identifiziert ist, der Leistungswandler ist, dessen jeweilige Hypothese in der entsprechenden erwarteten theoretischen Ausgabebetriebseigenschaft resultiert, die der gemessenen Ausgabebetriebseigenschaft des Übertragungsmediums (18) am nächsten entspricht.

**10.** Verfahren nach einem der vorstehenden Ansprüche, beinhaltend den nahen Leistungswandler (12; $12_3$), eine Vielzahl von hinteren Leistungswandlern (14, $14_2$) und eine Stromflusssteuerung, um innere Ströme auszugleichen, die zwischen den Leistungswandlern (12, 14, $14_2$) fließen, die miteinander verschaltet sind, wobei eine Stromausgabebetriebseigenschaft bei dem nahen Leistungswandler (12; $12_3$) gemessen ist und die Antwortcharakteristik des zeitunveränderlichen Modells zusätzlich zu der Verteilung von inneren Strömen unter den Leistungswandlern (12, $12_3$, $14_1$, $14_2$) beiträgt.

**11.** Verfahren nach Anspruch 10, wobei die Antwortcharakteristik zusätzlich zu der Verteilung von inneren Strömen unter den Leistungswandlern beiträgt, indem sie ein Gewichtungskoeffizienten entsprechend jedem inneren Stromfluss zwischen jeweiligen Paaren von miteinander verschalteten Leistungswandlern beinhaltet.

**12.** Gleichstromübertragungsnetzwerk, umfassend einen nahen Leistungswandler (12; $12_3$) und mindestens einen hinteren Leistungswandler (14; $14_1$, $14_2$), die miteinander durch einen oder mehrere Abschnitte (16, 42, 44) von Übertragungsmedium (18) verschaltet sind, wobei mindestens der vordere Leistungswandler (12; $12_3$) eine Steuereinheit beinhaltet, die programmiert ist zum:

a) Einrichten eines linearen zeitunveränderlichen Modells (22; 48; 58) des Übertragungsmediums (18), das zwischen dem oder jedem hinteren Leistungswandler (14; $14_1$; $14_2$) und dem vorderen Leistungswandler (12; $12_3$) liegt;
b) Bestimmen einer Antwortcharakteristik des zeitunveränderlichen Modells (22; 48; 58);
c) Messen einer Ausgabebetriebseigenschaft ($y_a$, $y_b$) des Übertragungsmediums (18) bei dem vorderen Leistungswandler (12; $12_3$);
d) Identifizieren eines hinteren Leistungswandlers (14; $14_1$, $14_2$) als einen hinteren Leistungswandler von Interesse (24);
e) Ableiten einer entsprechenden Eingabebetriebseigenschaft ($x_a$, $x_b$) des Übertragungsmediums (18) bei dem hinteren Leistungswandler (24) von Interesse, indem eine Umkehr der Antwortcharakteristik des zeitunveränderlichen Modells (22; 48; 58) auf die gemessene Ausgabebetriebseigenschaft ($y_a$, $y_b$) des Übertragungsmediums (18) bei dem vorderen Leistungswandler (12; $12_3$) angewendet wird; und
f) Vergleichen der abgeleiteten Eingabebetriebseigenschaft ($x_a$, $x_b$) des Übertragungsmediums (18) bei dem hinteren Leistungswandler von Interesse (24) mit einer Fehlercharakteristik, um zu bestimmen, ob es einen Fehler auf dem hinteren Leistungswandler von Interesse (24) gibt.

**Revendications**

**1.** Procédé de détection d'une erreur (26) sur un convertisseur de puissance d'extrémité distante (14 ; $14_1$, $14_2$) au sein d'un réseau de transmission à courant continu (10, 40, 70) comprenant un convertisseur de puissance d'extrémité proche (12, $12_3$) et au moins un convertisseur de puissance d'extrémité distante (14; $14_1$, $14_2$) interconnecté l'un à l'autre par une ou plusieurs portions (16, 42, 44) du support de transmission (18), le procédé comprenant les étapes consistant à :

(a) établir un modèle linéaire invariant dans le temps (22 ; 48 ; 58) du support de transmission (18) situé entre le ou chaque convertisseur de puissance d'extrémité distante (14 ; $14_1$, $14_2$) et le convertisseur de puissance d'extrémité proche (12 ; $12_3$) ;

(b) déterminer une caractéristique de réponse du modèle invariant dans le temps (22 ; 48 ; 58) ;

(c) mesurer une propriété de fonctionnement de sortie ($y_a$, $y_b$) du support de transmission (18) sur le convertisseur de puissance d'extrémité proche (12, $12_3$) ;

(d) identifier un convertisseur de puissance d'extrémité distante (14; $14_1$, $14_2$) en tant que convertisseur de puissance d'extrémité distante d'intérêt (24) ;

(e) dériver une propriété de fonctionnement d'entrée correspondante ($x_a$, $x_b$) du support de transmission (18) sur le convertisseur de puissance d'extrémité distante d'intérêt (24) en appliquant une valeur inverse de la caractéristique de réponse du modèle invariant dans le temps (22 ; 48 ; 58) à la propriété de fonctionnement de sortie mesurée ($y_a$, $y_b$) du support de transmission (18) sur le convertisseur de puissance d'extrémité proche (12 ; $12_3$) ; et

(f) comparer la propriété de fonctionnement d'entrée dérivée ($x_a$, $x_b$) du support de transmission (18) sur le convertisseur de puissance d'extrémité distante d'intérêt (24) avec une caractéristique d'erreur afin de déterminer s'il existe une erreur sur le convertisseur de puissance d'extrémité distante d'intérêt (24).

2. Procédé selon la revendication 1, dans lequel l'étape (f) de comparaison de la propriété de fonctionnement d'entrée dérivée ($x_a$, $x_b$) du support de transmission (18) sur le convertisseur de puissance d'extrémité distante d'intérêt (24) avec une caractéristique d'erreur afin de déterminer s'il existe une erreur (26) sur le convertisseur de puissance d'extrémité distante d'intérêt (24) inclut la prédiction quant à la propriété de fonctionnement d'entrée dérivée ($x_a$, $x_b$) répondant ou non à la caractéristique d'erreur et l'indication qu'il existe une erreur (26) sur le convertisseur de puissance d'extrémité distante d'intérêt (24) lorsqu'il est prédit que la propriété de fonctionnement d'entrée dérivée ($x_a$, $x_b$) répond à la caractéristique d'erreur.

3. Procédé selon la revendication 2, dans lequel la prédiction quant à la propriété de fonctionnement d'entrée dérivée ($x_a$, $x_b$) répondant ou non à la caractéristique d'erreur inclut la détermination d'une propriété de fonctionnement de sortie prévue au moins à l'avance.

4. Procédé selon l'une quelconque des revendications précédentes, dans lequel l'étape (b) de détermination d'une caractéristique de réponse du modèle invariant dans le temps (22 ; 48 ; 58) inclut l'établissement d'une ou de plusieurs des opérations suivantes pour décrire l'effet de transformation d'une ou de plusieurs portions du support de transmission (18) exercé sur la propriété de fonctionnement d'entrée ($x_a$, $x_b$) sur le ou chaque convertisseur de puissance d'extrémité distante (14 ; $14_1$, $14_2$) :

une réponse d'impulsion ;
une fonction de transfert ;
une équation différentielle ; et
une équation de différence.

5. Procédé selon l'une quelconque des revendications précédentes, incluant :

la mesure d'une ou des deux parmi une première propriété de fonctionnement de sortie ($y_a$) sous la forme d'une tension du support de transmission (18) sur le convertisseur de puissance d'extrémité proche (12 ; $12_3$) et une seconde propriété de fonctionnement de sortie ($Y_b$) sous la forme d'un courant du support de transmission (18) sur le convertisseur de puissance d'extrémité proche (12 ; $12_3$) ; et

la dérivation d'une ou des deux parmi une première propriété de fonctionnement d'entrée correspondante ($x_a$) sous la forme d'une tension du support de transmission (18) sur le convertisseur de puissance d'extrémité distante d'intérêt (24) et une seconde propriété de fonctionnement d'entrée correspondante ($x_b$) sous la forme d'un courant du support de transmission (18) sur le convertisseur de puissance d'extrémité distante d'intérêt (24).

6. Procédé selon la revendication 5, dans lequel les deux propriétés de fonctionnement de sortie de tension et de courant ($y_a$, $y_b$) sont mesurées et ensuite les deux propriétés de fonctionnement d'entrée de tension et de courant ($x_a$, $x_b$) sont dérivées, le procédé incluant de plus l'étape d'estimation de la puissance sur le convertisseur de puissance d'extrémité distante d'intérêt (24) à partir desdites propriétés de fonctionnement d'entrée de tension et de courant dérivées ($x_a$, $x_b$).

7. Procédé, selon l'une quelconque des revendications précédentes, de détection d'une erreur (26) sur un convertisseur de puissance d'extrémité distante (14; $14_1$, $14_2$) au sein d'un réseau de transmission à courant continu (10, 40, 70) incluant le convertisseur de puissance d'extrémité proche (12 ; $12_3$) et une pluralité de convertisseurs de puissance d'extrémités distantes (14 ; $14_1$, $14_2$), dans lequel l'étape (d) d'identification d'un convertisseur de puissance d'extrémité distante (14; 14₁, 14₂) en tant que convertisseur de puissance d'extrémité distante d'intérêt (24) inclut l'essai d'une hypothèse respective pour chaque convertisseur de puissance d'extrémité distante (14 ; 14₁, 14₂) attestant qu'une erreur s'est produite sur le convertisseur de puissance d'extrémité distante donné (14 ; 14₁, 14₂) et que le ou chaque autre convertisseur de puissance d'extrémité distante (14 ; 14₁, 14₂) continue à fonctionner normalement.

8. Procédé selon la revendication 7, dans lequel l'étape d'essai d'une hypothèse respective pour chaque convertisseur de puissance d'extrémité distante (14; 14₁, 14₂) inclut :

> l'attribution d'une propriété de fonctionnement d'entrée de niveau d'erreur estimé du support de transmission (18) sur le convertisseur de puissance d'extrémité distante donné sur lequel l'erreur (26) est supposée s'être produite ;
> l'utilisation d'une propriété de fonctionnement d'entrée précédente connue ($x_a$, $x_b$) du support de transmission (18) sur le ou chaque autre convertisseur de puissance d'extrémité distante (14 ; 14₁, 14₂) ;
> l'application de la caractéristique de réponse du modèle invariant dans le temps (22 ; 48 ; 58) à la propriété de fonctionnement d'entrée de niveau d'erreur estimé ($x_a$, $x_b$) du support de transmission (18) sur le convertisseur de puissance d'extrémité distante donné (14; 14₁, 14₂) sur lequel l'erreur est supposée s'être produite et à la propriété de fonctionnement d'entrée précédente connue du support de transmission sur le ou chaque autre convertisseur de puissance d'extrémité distante (14; 14₁, 14₂) ; afin d'obtenir une propriété de fonctionnement de sortie théorique prévue du support de transmission sur le convertisseur de puissance d'extrémité proche (12 ; 12₃) ; et
> la comparaison de la propriété de fonctionnement de sortie théorique prévue du support de transmission (18) sur le convertisseur de puissance d'extrémité proche (12 ; 12₃) avec la propriété de fonctionnement de sortie mesurée du support de transmission (18) sur le convertisseur de puissance d'extrémité proche (12 ; 12₃).

9. Procédé selon la revendication 8, dans lequel le convertisseur de puissance d'extrémité distante (14 ; 14₁, 14₂) identifié comme le convertisseur de puissance d'extrémité distante d'intérêt (24) est le convertisseur de puissance dont l'hypothèse respective aboutit à la propriété de fonctionnement de sortie théorique prévue correspondante se rapprochant le plus de la propriété de fonctionnement de sortie mesurée du support de transmission (18).

10. Procédé selon l'une quelconque des revendications précédentes, incluant le convertisseur de puissance d'extrémité proche (12 ; 12₃), une pluralité de convertisseurs de puissance d'extrémités distantes (14, 14₂) et un régulateur de flux de courant pour équilibrer les courants internes circulant entre les convertisseurs de puissance (12, 14, 14₂) qui sont mutuellement interconnectés les uns aux autres, dans lequel une propriété de fonctionnement de sortie de courant est mesurée sur le convertisseur de puissance d'extrémité proche (12 ; 12₃) et la caractéristique de réponse du modèle invariant dans le temps représente un facteur supplémentaire dans la répartition des courants internes parmi lesdits convertisseurs de puissance (12, 12₃, 14₁, 14₂).

11. Procédé selon la revendication 10, dans lequel la caractéristique de réponse représente un facteur supplémentaire dans la répartition des courants internes parmi lesdits convertisseurs de puissance en incluant un coefficient de pondération correspondant à chaque flux de courant interne entre des paires respectives de convertisseurs de puissance mutuellement interconnectés.

12. Réseau de transmission à courant continu comprenant un convertisseur de puissance d'extrémité proche (12 ; 12₃) et au moins un convertisseur de puissance d'extrémité distante (14 ; 14₁, 14₂) interconnectés l'un à l'autre par une ou plusieurs portions (16, 42, 44) du support de transmission (18), au moins le convertisseur de puissance d'extrémité proche (12; 12₃) incluant une unité de commande programmée pour :

> (a) établir un modèle linéaire invariant dans le temps (22 ; 48 ; 58) du support de transmission (18) situé entre le ou chaque convertisseur de puissance d'extrémité distante (14 ; 14₁, 14₂) et le convertisseur de puissance d'extrémité proche (12 ; 12₃) ;
> (b) déterminer une caractéristique de réponse du modèle invariant dans le temps (22 ; 48 ; 58) ;
> (c) mesurer une propriété de fonctionnement de sortie ($y_a$, $y_b$) du support de transmission (18) sur le convertisseur de puissance d'extrémité proche (12 ; 12₃) ;
> (d) identifier un convertisseur de puissance d'extrémité distante (14; 14₁, 14₂) en tant que convertisseur de puissance d'extrémité distante d'intérêt (24) ;
> (e) dériver une propriété de fonctionnement d'entrée correspondante ($x_a$, $x_b$) du support de transmission (18) sur le convertisseur de puissance d'extrémité distante (24) d'intérêt en appliquant une valeur inverse de la réponse caractéristique du modèle invariant dans le temps (22 ; 48 ; 58) à la propriété de fonctionnement de

sortie mesurée ($y_a$, $y_b$) du support de transmission (18) sur le convertisseur de puissance d'extrémité proche (12 ; $12_3$) ; et

(f) comparer la propriété de fonctionnement d'entrée dérivée ($x_a$, $x_b$) du support de transmission (18) sur le convertisseur de puissance d'extrémité distante d'intérêt (24) avec une caractéristique d'erreur afin de déterminer s'il existe une erreur sur le convertisseur de puissance d'extrémité distante d'intérêt (24).

Figure 1(a)

Figure 1(b)

Figure 2

Figure 3

40

14₁

16,18
h₁

h₃

46

12

14₂

h₂

42,18

44,18

**Figure 4(a)**

48

50

$x_1$ — h₁ — + ⟳ — h₃ — y
        +

$x_2$ — h₂

**Figure 4(b)**

58

$x_1$ — h₁ — + ⟳ — hₙ — y
        +

$x_2$ — h₂ — + ⟳
        +

$x_{N-1}$ — h_{N-1}

**Figure 4(c)**

Figure 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015172810 A1